# FASCICULE DE BREVET EUROPEEN

(11) **EP 2 789 220 B1**
(45) Date de publication et mention de la délivrance du brevet: **06.07.2016**
(21) Numéro de dépôt: 12795396.6
(22) Date de dépôt: 26.11.2012
(51) Int. Cl.: H02B 1/56, H05K 7/20

(54) **ARMOIRE ELECTRIQUE A DISSIPATION THERMIQUE AMELIOREE**
SCHALTSCHRANK MIT VERBESSERTER WÄRMEABLEITUNG
ELECTRICAL CABINET WITH IMPROVED HEAT DISSIPATION

(30) Priorité: 05.12.2011 FR 1161128
(43) Date de publication de la demande: 15.10.2014
(73) Titulaire: Schneider Electric Industries SAS, 92500 Rueil-Malmaison (FR)
(72) Inventeur: PERRIN, Alain, 38500 Saint Nicolas de Macherin (FR); WATERLOT, Frédéric, 73190 Saint Baldoph (FR); LINARES, Louis, 38660 La Terrasse (FR); LEPRETRE, Pascal, 73800 Les Marches (FR); LOPEZ, Josep, 08390 Barcelona (ES)
(74) Mandataire: Dufresne, Thierry
(86) Numéro de dépôt international: PCT/EP2012/073563
(87) Numéro de publication internationale: WO 2013/083421

(56) Documents cités:
- DE-A1- 10 356 424
- DE-A1-102004 030 675
- DE-U1- 9 111 434
- US-B1- 6 538 883

## Description

### Domaine technique de l'invention

La présente invention se rapporte à une armoire électrique à dissipation thermique améliorée.

### Etat de la technique

Il est connu du document référencé DE102009054011A1 une armoire électrique proposant une solution pour améliorer le refroidissement des appareils électriques logés dans l'armoire électrique. Cette solution consiste :
- à séparer l'armoire en deux espaces, un premier espace situé vers l'avant, comportant des appareils électriques à refroidir, et un deuxième espace situé vers l'arrière et comportant une arrivée d'air froid venant de l'extérieur et un système de ventilation permettant de faire circuler efficacement cet air froid venant de l'extérieur et,
- à réaliser des ouvertures entre les différents appareils électriques pour permettre au flux d'air froid de passer du deuxième espace vers le premier espace et de balayer tous les appareils électriques. Les ouvertures sont par exemple prolongées par des goulottes afin d'amener le flux d'air au plus proche de la zone de l'appareil électrique à refroidir.

Cette solution nécessite de réaliser une ouverture vers l'extérieur, elle n'est donc pas adaptée pour une armoire étanche, par exemple conforme à la norme IEC 60529 avec un indice IP55. De plus, dans cette solution, toutes les parties des appareils électriques sont destinées à être à une même température alors que tous les appareils électriques ne nécessitent pas forcément le même niveau de refroidissement.

Une armoire électrique est également connue du document DE9111434U1.

Le but de l'invention est donc de proposer une armoire électrique dans laquelle des appareils électriques peuvent être refroidis efficacement, même si l'armoire électrique est étanche, et dans laquelle il est possible que certains appareils électriques qui ne nécessitent pas d'être refroidis, ne le soient pas ou peu.

### Exposé de l'invention

Ce but est atteint par une armoire électrique comportant une partie avant et une partie arrière, et destinée à recevoir des unités fonctionnelles électriques comportant chacune un support et plusieurs appareils électriques agencés sur le support, ladite armoire électrique comprenant également :
- des moyens de fixation desdites unités fonctionnelles électriques, lesdits moyens de fixation étant agencés pour recevoir lesdites unités fonctionnelles électriques suivant un plan de séparation délimitant un premier espace situé vers la partie avant et un deuxième espace situé vers la partie arrière,
- une cloison séparant le deuxième espace en un premier sous-espace situé vers la partie avant et un deuxième sous-espace situé vers la partie arrière, la cloison étant agencée dans l'armoire électrique pour former au moins deux passages permettant à un flux d'air de circuler entre le premier sous-espace et le deuxième sous-espace,
- une source de refroidissement destinée à être agencée au contact dudit flux d'air.

Selon une particularité, l'armoire électrique comporte une unité fonctionnelle de ventilation fixée sur les moyens de fixation et comportant un système de ventilation situé dans le premier sous-espace.

Selon une autre particularité, l'armoire électrique comporte une unité fonctionnelle de ventilation fixée sur les moyens de fixation et comportant un système de ventilation situé dans le premier espace.

Selon une autre particularité, la source de refroidissement comporte des ailettes d'échange thermique situées dans le deuxième sous-espace.

Selon une autre particularité, la cloison comporte des ailettes d'échange thermique situées dans le deuxième sous-espace.

Selon une autre particularité, l'armoire électrique comporte au moins deux unités fonctionnelles électriques montées le long du plan de séparation et une ouverture réalisée entre les deux unités fonctionnelles électriques.

Selon une autre particularité, une unité fonctionnelle électrique comporte un appareil électrique traversant le plan de séparation de manière à disposer d'une première partie située dans le premier espace et d'une deuxième partie située dans le premier sous-espace. La deuxième partie de l'appareil électrique comporte par exemple un système de ventilation.

Selon une autre particularité, la deuxième partie de l'appareil électrique comporte une surface d'appui positionnée contre la cloison.

Selon une autre particularité, l'armoire électrique comporte une unité de refroidissement fixée sur les moyens de fixation.

Selon une autre particularité, l'unité de refroidissement comporte un module d'échange thermique traversant le plan de séparation et la cloison.

Selon une autre particularité, le volume du premier espace est plus important que le volume du deuxième espace.

### Brève description des figures

D'autres caractéristiques et avantages vont apparaître dans la description détaillée qui suit faite en regard des dessins annexés dans lesquels :
- la figure 1 représente, vu de côté, l'intérieur de l'armoire électrique de l'invention, selon une première configuration,
- la figure 2 représente, vu de côté, l'intérieur de l'armoire électrique de l'invention, selon une deuxième configuration,
- la figure 3 représente, vu de côté, l'intérieur de l'armoire électrique de l'invention, selon une troisième configuration,
- la figure 4 représente, vu de côté, l'intérieur de l'armoire électrique de l'invention, selon une quatrième configuration,
- la figure 5 représente, vu de côté, l'intérieur de l'armoire électrique de l'invention, selon une cinquième configuration,
- la figure 6 représente, vu de face, l'intérieur de l'armoire électrique.

### Description détaillée d'au moins un mode de réalisation

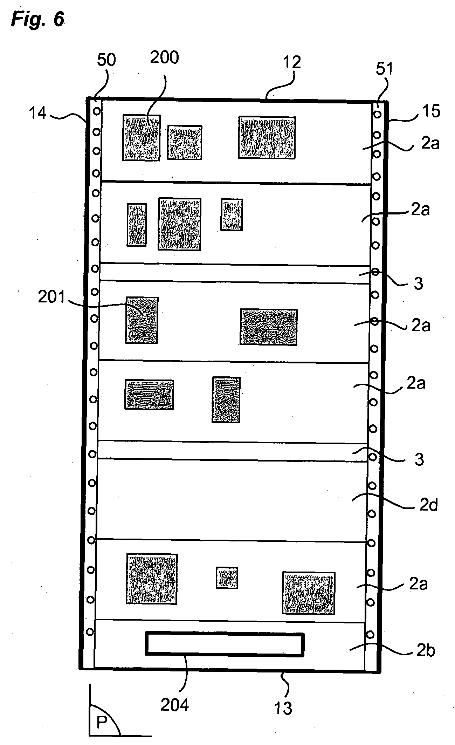

L'invention concerne une armoire électrique 1. L'armoire électrique 1 est préférentiellement de forme parallélépipédique. Bien entendu, une armoire cylindrique à section circulaire ou ayant une section d'une forme différente pourrait tout à fait être envisagée. Dans la suite de la description, on s'intéressera à une armoire électrique de forme parallélépipédique. L'armoire électrique comporte ainsi une paroi avant 10, une paroi arrière 11, une paroi supérieure 12, une paroi inférieure 13 et deux parois latérales 14, 15 (visibles sur la figure 6).

L'armoire électrique 1 de l'invention pourra notamment être étanche, par exemple conforme à la norme IEC 60529 avec un indice IP55. La solution de dissipation thermique décrite ci-dessous est parfaitement adaptée pour refroidir des appareils électriques logés dans une armoire électrique étanche de ce type mais il faut comprendre qu'elle peut s'adapter à une armoire non étanche ou d'un niveau d'étanchéité différent.

La paroi avant 10 de l'armoire électrique 1 comporte par exemple une porte d'accès à l'intérieur de l'armoire.

A l'intérieur, l'armoire électrique 1 comporte des moyens de fixation destinés à accueillir différentes unités fonctionnelles, notamment des unités fonctionnelles électriques 2a, des unités fonctionnelles de ventilation 2b et/ou des unités fonctionnelles de refroidissement 2c. Ces unités fonctionnelles sont combinées dans l'armoire en tenant compte des applications à commander ou contrôler et de différentes contraintes, notamment thermiques.

Chaque unité fonctionnelle 2a, 2b, 2c comporte un support 20 adapté pour se fixer sur les moyens de fixation et un ou plusieurs éléments fixés sur le support 20 pour remplir par exemple des fonctions de contrôle-commande, de ventilation ou de refroidissement.

On entend par unité fonctionnelle électrique 2a, une unité fonctionnelle qui comporte un ou plusieurs appareils électriques, tels que par exemple un disjoncteur, un contacteur électromécanique, un départ-moteur, un variateur de vitesse, un démarreur, un filtre ou une résistance de freinage. Des appareils électriques de ce type sont par exemple rassemblés dans une unité fonctionnelle électrique 2a selon leur fonction et/ou leurs caractéristiques thermiques. Certaines unités fonctionnelles électriques 2a comportent juste des appareils électriques de contrôle/commande 200, qui ne nécessitent pas forcément d'être refroidis alors que d'autres unités fonctionnelles électriques peuvent comporter des appareils électriques de puissance 201 qui sont susceptibles de beaucoup chauffer et qu'il est donc nécessaire de refroidir.

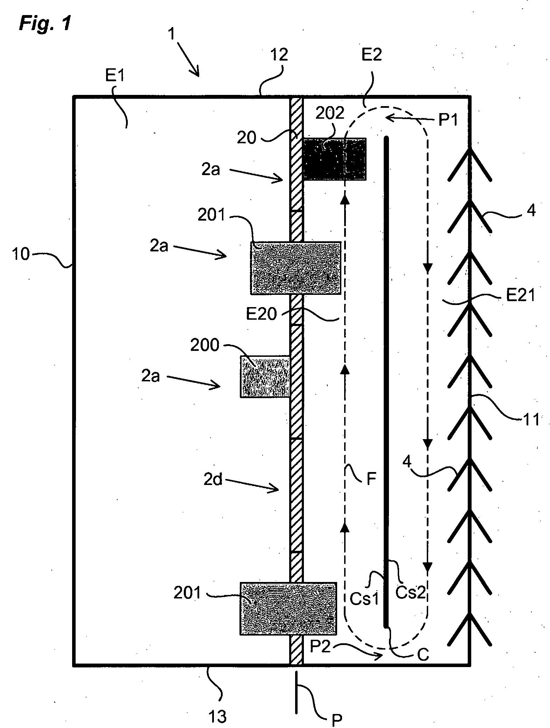

Selon l'invention, les moyens de fixation sont par exemple constitués de deux montants 50, 51 verticaux parallèles (figure 6), entre lesquels peut venir se fixer chaque support 20 de chaque unité fonctionnelle 2a, 2b, 2c. Les deux montants verticaux sont positionnés dans un plan, dit plan de séparation P, qui est parallèle aux parois avant 10 et arrière 11 de l'armoire électrique 1. Les unités fonctionnelles sont fixées sur les moyens de fixation selon le plan de séparation P. Des unités fonctionnelles 2, 2b, 2c peuvent être positionnées de manière adjacente suivant le plan de séparation P de manière à former une paroi de séparation entre un premier espace E1 situé vers la partie avant de l'armoire électrique 1 et un deuxième espace E2 situé vers la partie arrière de l'armoire électrique 1. Des unités fonctionnelles d'obturation 2d (figure 1), ne portant aucun appareil ou élément, peuvent également être prévues pour réaliser une paroi de séparation complète sur toute la hauteur de l'armoire électrique 1. Bien entendu, pour faire varier les volumes des deux espaces E1, E2, la position en profondeur des montants, et donc de la paroi de séparation, peut être adaptée.

Préférentiellement, le premier espace E1 présente un volume plus important que celui du deuxième espace E2.

Selon l'invention, l'armoire électrique 1 comporte également, dans le deuxième espace E2, une cloison C s'étendant suivant un plan vertical parallèle au plan de séparation P. Cette cloison C permet ainsi de diviser le deuxième espace E2 en un premier sous-espace E20 situé vers la partie avant de l'armoire électrique 1 et un deuxième sous-espace E21 situé vers la partie arrière de l'armoire électrique 1. La position de cette cloison est ajustable en profondeur pour pouvoir faire varier les volumes des deux sous-espaces E20, E21. Cette cloison C est fixée à l'intérieur de l'armoire électrique 1 de manière à laisser au moins deux passages P1, P2 permettant à un flux d'air de circuler entre le premier sous-espace E20 et le deuxième sous-espace E21. Préférentiellement, un premier passage P1 est réalisé en haut de l'armoire électrique 1 et un deuxième passage P2 est réalisé dans le bas de l'armoire électrique. La cloison C comporte une face avant Cs1 située du côté du premier sous-espace E20 du deuxième espace et une face arrière Cs2 située du côté du deuxième sous-espace E21 du deuxième espace. La position de la cloison C est également ajustable en hauteur de manière à pouvoir faire varier la taille des passages P1, P2.

Selon l'invention, chaque support 20 d'unité fonctionnelle fixée sur les moyens de fixation présente deux faces parallèles au plan de séparation P, une face avant située du côté du premier espace E1 et une face arrière située du côté du premier sous-espace E20 du deuxième espace.

En référence à la figure 1, selon le type d'appareil électrique employé sur les unités fonctionnelles électriques 2a, divers agencements sont possibles :
- Certains appareils électriques seront entièrement situés dans le premier espace E1, c'est-à-dire fixés sur la face avant du support 20 de l'unité fonctionnelle électrique 2a. Ces appareils électriques présents dans le premier espace E1 sont par exemple des appareils de contrôle-commande 200 tels que des disjoncteurs ou des contacteurs électromécaniques.
- Certains appareils électriques seront situés uniquement dans le premier sous-espace E20 du deuxième espace, c'est-à-dire fixés sur la face arrière du support 20 de l'unité fonctionnelle électrique 2a. Ces appareils électriques 202 présents uniquement dans le premier sous-espace E20 du deuxième espace sont par exemple des inductances de lissage ou des résistances de freinage.
- Certains appareils électriques pourront traverser leur support 20 de manière à présenter une première partie située dans le premier espace E1 et une deuxième partie située dans le premier sous-espace E20 du deuxième espace. Ces appareils électriques situés en partie dans le premier espace et dans le premier sous-espace du deuxième espace sont par exemple des appareils de puissance 201 du type variateur de vitesse, la partie contrôle du variateur de vitesse étant située à l'avant et la partie puissance dotée des transistors de puissance située à l'arrière. La partie puissance pourra notamment comporter un système de ventilation intégré.

Selon l'invention, le volume intérieur de l'armoire électrique 1 peut ainsi être divisé en trois zones thermiques distinctes :
- une zone froide formée par le premier espace E1 car elle est destinée à recevoir des appareils électriques ou parties d'appareils qui ne chauffent pas ou très peu,
- une zone d'échauffement formée par le premier sous-espace E20 du deuxième espace car elle est destinée à recevoir des appareils ou parties d'appareils qui chauffent,
- une zone de refroidissement formée par le deuxième sous-espace E21 du deuxième espace car elle est en contact avec une source de refroidissement, par exemple formée des parois de l'armoire (parois arrière 11 et latérales), qui sont en contact avec l'air ambiant, le bâti d'une machine ou avec la zone froide d'une armoire électrique adjacente.

Selon l'invention, un flux d'air F est ainsi créé entre la zone d'échauffement et la zone de refroidissement, ce flux d'air circulant d'une zone à l'autre par les deux passages P1, P2 définis ci-dessus.

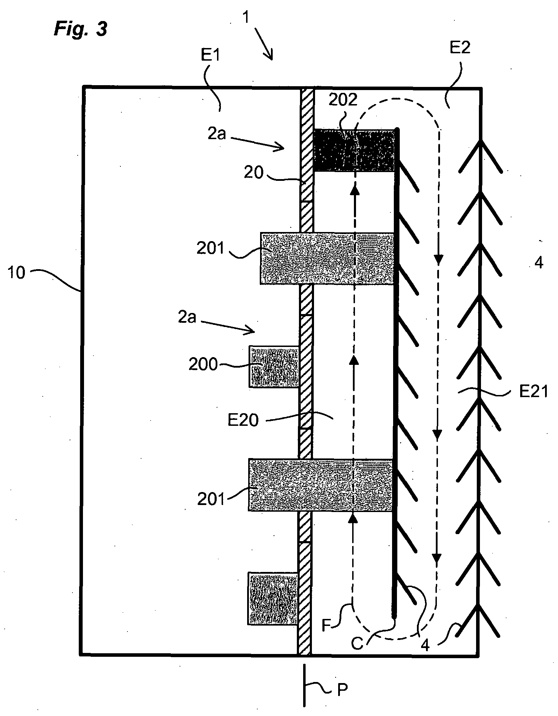

Selon l'invention, l'armoire électrique 1 peut comporter des ailettes 4 d'échange thermique placées sur différentes parois de manière à augmenter la surface d'échange thermique. Les ailettes 4 d'échange thermique sont orientées dans le sens de circulation du flux d'air F. En référence aux figures, des ailettes 4 d'échange thermique peuvent ainsi être positionnées sur la paroi arrière 11 de l'armoire électrique 1, sur la face externe de celle-ci et/ou sur la face interne de celle-ci. Des ailettes 4 d'échange thermique peuvent également être positionnées sur la cloison C, sur la face arrière Cs2 de celle-ci. Ce dernier groupe d'ailettes 4 d'échange thermique présente un intérêt lorsque l'arrière d'un appareil électrique est fixé sur la face avant Cs1 de la cloison C (figure 3).

Dans une première configuration représentée sur la figure 1, dans laquelle la paroi de séparation est présente sur toute la hauteur de l'armoire électrique 1, ce flux d'air F est maintenu dans le deuxième espace E2 et circule entre le premier sous-espace E20 du deuxième espace et le deuxième sous-espace E21 du deuxième espace.

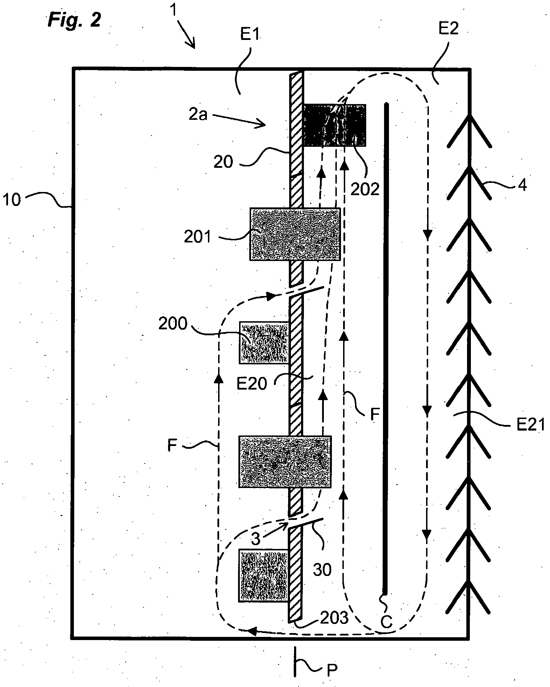

Dans une deuxième configuration représentée sur la figure 2, des ouvertures 3 sont distribuées entre certaines unités fonctionnelles pour faire communiquer le premier espace E1 avec le deuxième espace E2. Le flux d'air F peut donc également circuler de la zone froide vers la zone d'échauffement par une ou plusieurs ouvertures 3. Le flux d'air F vient balayer également les appareils électriques situés uniquement dans le premier espace E1. Préférentiellement, l'arête supérieure et l'arête inférieure de chaque support 20 d'une unité fonctionnelle peuvent être biseautées, les biseaux 203 étant orientés dans le sens de circulation du flux d'air F. Ainsi, lorsqu'une ouverture 3 est volontairement créée entre deux unités fonctionnelles, le flux d'air F circule plus facilement entre le premier espace E1 et le premier sous-espace E20 du deuxième espace. Une ailette 30 de circulation peut également être prévue sur l'ouverture 3 pour mieux orienter le flux d'air F. Dans ce flux d'air, le flux d'air chaud présent dans le premier sous-espace E20 est renvoyé vers l'arrière tandis que le flux d'air refroidi est dirigé directement vers la partie chaude de l'appareil de puissance (201 ou 202) ou son système de dissipation thermique embarqué. De par l'échauffement dans le premier sous-espace E20, la vitesse de circulation de l'air chaud dans le premier sous-espace E20 est supérieure à celle de l'air refroidi ; ainsi l'air refroidi est aspiré par effet venturi et plus le gradient de température est élevé, plus importante est la vitesse de circulation du flux d'air. Ainsi naît une autorégulation qui dépend du gradient de température et aussi des volumes d'air relatifs des espaces E1, E20 et E21 de l'armoire électrique.

Selon une autre configuration représentée sur la figure 3, lorsque la puissance dissipée est plus importante, les points chauds des appareils sont directement collés à la cloison C, cette dernière faisant office de radiateur.

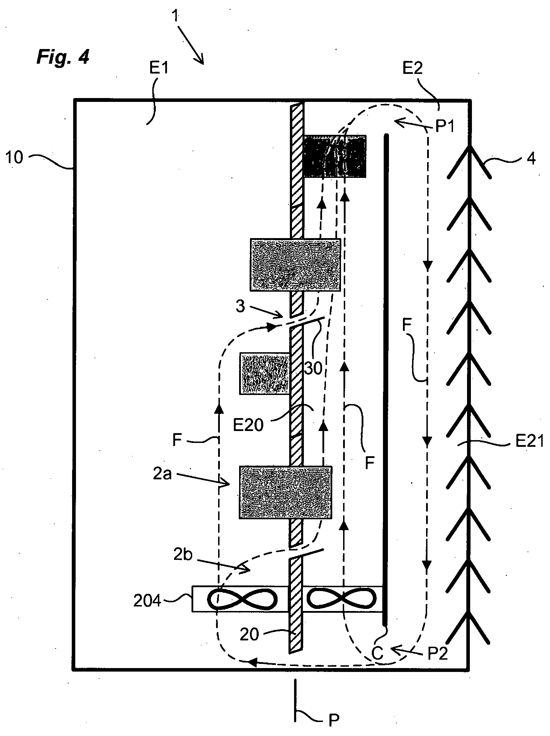

Selon une autre configuration représentée sur la figure 4, pour faciliter la circulation du flux d'air F entre la zone d'échauffement et la zone de refroidissement ou entre la zone d'échauffement et la zone froide, l'armoire électrique 1 peut comporter une ou plusieurs unités fonctionnelles de ventilation 2b. Ces unités fonctionnelles de ventilation 2b peuvent comporter un ou plusieurs systèmes de ventilation 204. Une unité fonctionnelle de ce type est fixée sur les moyens de fixation de l'armoire électrique 1 et comporte un système de ventilation 204 fixé, soit sur la face avant de son support 20, soit sur la face arrière de son support 20, ou un système de ventilation fixé sur chaque face de son support 20 (figure 4).

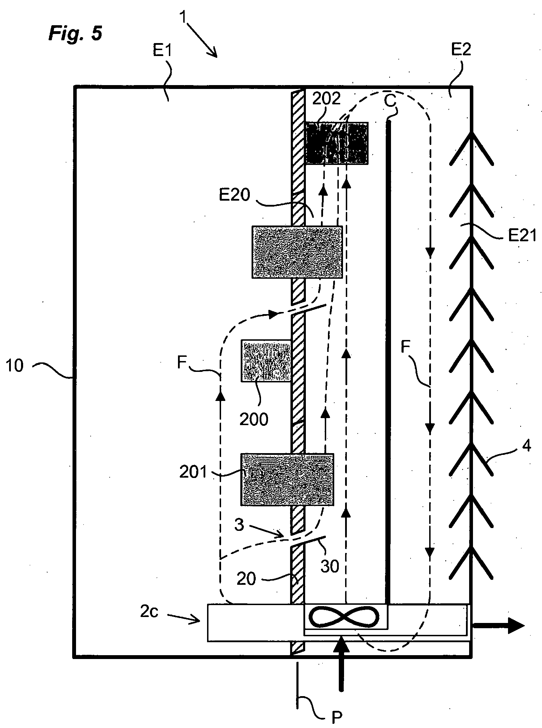

Selon une autre configuration représentée sur la figure 5, l'armoire électrique 1 peut également comporter une unité fonctionnelle de refroidissement 2c comprenant un module d'échange thermique. Cette unité fonctionnelle de refroidissement 2c permet d'améliorer le refroidissement de l'air dans l'armoire électrique 1. Le module d'échange thermique est par exemple positionné à travers le plan de séparation P et la cloison C de manière à recevoir le flux d'air F provenant de la zone de refroidissement pour refroidir ce flux d'air F et le réinjecter dans la zone d'échauffement et dans la zone froide. Une autre configuration peut bien entendu être envisagée.

Selon l'invention, les différentes caractéristiques de l'armoire électrique 1 présentées ci-dessus dans les différentes configurations représentées sur les figures peuvent tout à fait être combinées entre elles pour s'adapter aux appareils électriques logés dans l'armoire électrique, à la situation et à l'environnement de l'armoire électrique.

## Revendications

1. Armoire électrique (1) comportant une partie avant et une partie arrière, et destinée à recevoir des unités fonctionnelles électriques (2a) comportant chacune un support (20) et plusieurs appareils électriques (200, 201, 202) agencés sur une face avant du support (20), sur une face arrière du support (20) ou traversant le support (20), ladite armoire électrique (1) comprenant également :
- des moyens de fixation desdites unités fonctionnelles électriques (2a), lesdits moyens de fixation étant agencés pour recevoir lesdits supports (20) desdites unités fonctionnelles électriques suivant un plan de séparation (P) délimitant un premier espace (E1) situé vers la partie avant de l'armoire électrique (1) et un deuxième espace (E2) situé vers la partie arrière de l'armoire électrique (1), - un flux d'air (F) circulant dans le deuxième espace (E2),
- une source de refroidissement destinée à être agencée au contact dudit flux d'air (F),
**caractérisée en ce que** l'armoire électrique (1) comporte :
- une cloison (C) s'étendant suivant un plan vertical parallèle au plan de séparation (P) et séparant le deuxième espace (E2) en un premier sous-espace (E20) situé vers la partie avant de l'armoire électrique (1) et un deuxième sous-espace (E21) situé vers la partie arrière de l'armoire électrique (1), la cloison (C) étant agencée dans l'armoire électrique (1) pour former au moins deux passages (P1, P2) permettant au flux d'air (F) de circuler entre le premier sous-espace (E20) et le deuxième sous-espace (E21),
- une zone thermique froide formée par le premier espace (E1) et destinée à recevoir des appareils électriques ou parties d'appareils électriques qui ne chauffent pas ou très peu,
- une zone thermique d'échauffement formée par le premier sous-espace (E20) du deuxième espace (E2) et destinée à recevoir des appareils ou parties d'appareils qui chauffent,
- une zone thermique de refroidissement formée par le deuxième sous-espace (E21) du deuxième espace (E2) et en contact avec ladite source de refroidissement.

2. Armoire électrique selon la revendication 1, **caractérisée en ce qu'**elle comporte une unité fonctionnelle de ventilation (2b) fixée sur les moyens de fixation et comportant un système de ventilation situé dans le premier sous-espace (E20).

3. Armoire électrique selon la revendication 1, **caractérisée en ce qu'**elle comporte une unité fonctionnelle de ventilation (2b) fixée sur les moyens de fixation et comportant un système de ventilation situé dans le premier espace (E1).

4. Armoire électrique selon l'une des revendications 1 à 3, **caractérisée en ce que** la source de refroidissement comporte des ailettes (4) d'échange thermique situées dans le deuxième sous-espace (E21).

5. Armoire électrique selon l'une des revendications 1 à 4, **caractérisée en ce que** la cloison (C) comporte des ailettes (4) d'échange thermique situées dans le deuxième sous-espace (E21).

6. Armoire électrique selon l'une des revendications 1 à 5, **caractérisée en ce qu'**elle comporte au moins deux unités fonctionnelles électriques (2a) montées le long du plan de séparation (P) et **en ce qu'**elle comporte une ouverture réalisée entre les deux unités fonctionnelles électriques (2a).

7. Armoire électrique selon l'une des revendications 1 à 6, **caractérisée en ce qu'**une unité fonctionnelle électrique (2a) comporte un appareil électrique (201) traversant le plan de séparation (P) de manière à disposer d'une première partie située dans le premier espace (E1) et d'une deuxième partie située dans le premier sous-espace (E20).

8. Armoire électrique selon la revendication 7, **caractérisée en ce que** la deuxième partie de l'appareil électrique (201) comporte un système de ventilation.

9. Armoire électrique selon l'une des revendications 1 à 8, **caractérisée en ce que** la deuxième partie de l'appareil électrique (201) comporte une surface d'appui positionnée contre la cloison (C).

10. Armoire électrique selon l'une des revendications 1 à 9, **caractérisée en ce qu'**elle comporte une unité fonctionnelle de refroidissement (2c) fixée sur les moyens de fixation.

11. Armoire électrique selon la revendication 10, **caractérisée en ce que** l'unité fonctionnelle de refroidissement (2c) comporte un module d'échange thermique traversant le plan de séparation (P) et la cloison (C).

12. Armoire électrique selon l'une des revendications 1 à 11, **caractérisée en ce que** le volume du premier espace (E1) est plus important que le volume du deuxième espace (E2).

## Patentansprüche

1. Schaltschrank (1), der einen vorderen Teil und einen hinteren Teil aufweist und dazu bestimmt ist, funktionale elektrische Einheiten (2a) aufzunehmen, die jeweils einen Träger (20) und mehrere elektrische Geräte (200, 201, 202), die auf einer vorderen Fläche des Trägers (20) oder einer hinteren Fläche des Trägers (20) angeordnet sind oder durch den Träger (20) verlaufen, umfassen, wobei der Schaltschrank (1) außerdem Folgendes umfasst:
- Mittel zum Befestigen der funktionalen elektrischen Einheiten (2a), wobei die Befestigungsmittel dafür ausgelegt sind, die Träger (20) der funktionalen elektrischen Einheiten längs einer Trennebene (P), die einen ersten Raum (E1), der sich auf Seiten des vorderen Teils des Schaltschranks (1) befindet, und einen zweiten Raum (E2), der sich auf Seiten des hinteren Teils des Schaltschranks (1) befindet, begrenzt, aufzunehmen,
- wobei in dem zweiten Raum (E2) ein Luftstrom (F) zirkuliert,
- eine Kühlungsquelle, die dazu bestimmt ist, in Kontakt mit dem Luftstrom (F) angeordnet zu sein,
**dadurch gekennzeichnet**, das der Schaltschrank (1) Folgendes umfasst:
- eine Trennwand (C), die sich längs einer vertikalen Ebene parallel zu der Trennebene (P) erstreckt und den zweiten Raum (E2) in einen ersten Unterraum (E20), der sich auf Seiten des vorderen Teils des Schaltschranks (1) befindet, und einen zweiten Unterraum (E21), der sich auf Seiten des hinteren Teils des Schaltschranks (1) befindet, unterteilt, wobei die Trennwand (C) in dem Schaltschrank (1) angeordnet ist, um wenigstens zwei Durchlässe (P1, P2) zu bilden, die dem Luftstrom (F) ermöglichen, zwischen dem ersten Unterraum (E20) und dem zweiten Unterraum (E21) zu zirkulieren,
- eine kalte thermische Zone, die durch den ersten Raum (E1) gebildet ist und dazu vorgesehen ist, die elektrischen Geräte oder Teile elektrischer Geräte, die sich nicht oder nur sehr wenig erhitzen, aufzunehmen,
- eine sich erwärmende thermische Zone, die durch den ersten Unterraum (E20) des zweiten Raums (E2) gebildet ist und dazu bestimmt ist, Geräte oder Teile von Geräten, die sich erwärmen, aufzunehmen,
- eine kühlende thermische Zone, die durch den zweiten Unterraum (E21) des zweiten Raums (E2) gebildet ist und mit der Kühlungsquelle in Kontakt ist.

2. Schaltschrank nach Anspruch 1, **dadurch gekennzeichnet, dass** er eine funktionale Lüftungseinheit (2b) umfasst, die an den Befestigungsmitteln befestigt ist und ein Lüftungssystem aufweist, das sich in dem ersten Unterraum (E20) befindet.

3. Schaltschrank nach Anspruch 1, **dadurch gekennzeichnet, dass** er eine funktionale Lüftungseinheit (2b) umfasst, die an den Befestigungsmitteln befestigt ist und ein Belüftungssystem aufweist, das sich in dem ersten Raum (E1) befindet.

4. Schaltschrank nach einem der Ansprüche 1 bis 3, **dadurch gekennzeichnet, dass** die Kühlungsquelle Wärmeaustauschflügel (4) aufweist, die sich in dem zweiten Unterraum (E21) befinden.

5. Schaltschrank nach einem der Ansprüche 1 bis 4, **dadurch gekennzeichnet, dass** die Trennwand (C) Wärmeaustauschflügel (4) umfasst, die sich in dem zweiten Unterraum (E21) befinden.

6. Schaltschrank nach einem der Ansprüche 1 bis 5, **dadurch gekennzeichnet, dass** er wenigstens zwei funktionale elektrische Einheiten (2a) umfasst, die längs der Trennebene (P) montiert sind, und dass er eine Öffnung aufweist, die zwischen den zwei funktionalen elektrischen Einheiten (2a) verwirklicht ist.

7. Schaltschrank nach einem der Ansprüche 1 bis 6, **dadurch gekennzeichnet, dass** eine funktionale elektrische Einheit (2a) ein elektrisches Gerät (201) umfasst, das durch die Trennebene (P) in der Weise verläuft, dass sich ein erster Teil in dem ersten Raum (E1) befindet und sich ein zweiter Teil in dem ersten Unterraum (E20) befindet.

8. Schaltschrank nach Anspruch 7, **dadurch gekennzeichnet, dass** der zweite Teil des elektrischen Geräts (201) ein Lüftungssystem aufweist.

9. Schaltschrank nach einem der Ansprüche 1 bis 8, **dadurch gekennzeichnet, dass** der zweite Teil des elektrischen Geräts (201) eine an der Trennwand (C) positionierte Abstützoberfläche aufweist.

10. Schaltschrank nach einem der Ansprüche 1 bis 9, **dadurch gekennzeichnet, dass** er eine funktionale Kühlungseinheit (2c) umfasst, die an den Befestigungsmitteln befestigt ist.

11. Schaltschrank nach Anspruch 10, **dadurch gekennzeichnet, dass** die funktionale Kühlungseinheit (2c) ein Wärmeaustauschmodul umfasst, das durch die Trennebene (P) und die Trennwand (C) verläuft.

12. Schaltschrank nach einem der Ansprüche 1 bis 11, **dadurch gekennzeichnet, dass** das Volumen des ersten Raums (E1) größer als das Volumen des zweiten Raums (E2) ist.

## Claims

1. An electrical cabinet (1) comprising a front part and a rear part, and intended to receive functional electrical units (2a) each comprising a support (20) and a plurality of electrical devices (200, 201, 202) arranged on a front face of the support (20), on a rear face of the support (20) or passing through the support (20), said electrical cabinet (1) also comprising:
- means for fastening said functional electrical units (2a), said fastening means being arranged to receive said functional electrical units on a separation plane (P) delimiting a first space (E1) situated toward the front part of the electrical cabinet (1) and a second space (E2) situated toward the rear part of the electrical cabinet (1),
- an airflow (F) circulating in the second space (E2),
- a cooling source intended to be arranged in contact with said airflow (F),
**characterized in that** the electrical cabinet (1) comprises:
- a partition (C) extending along a vertical plane parallel to the separation plane (P) and dividing the second space (E2) into a first subspace (E20) situated toward the front part of the electrical cabinet (1) and a second subspace (E21) situated toward the rear part of the electrical cabinet (1), the partition (C) being arranged in the electrical cabinet (1) to form at least two passages (P1, P2) enabling the airflow (F) to circulate between the first subspace (E20) and the second subspace (E21),
- a cold thermal zone formed by the first space (E1) and intended to receive electrical devices or parts of electrical devices which do not heat up or heat up very little,
- a heating thermal zone formed by the first subspace (E20) of the second space (E2) and intended to receive devices or parts of devices which heat up,
- a cooling thermal zone formed by the second subspace (E21) of the second space (E2) and which it is in contact with said cooling source.

2. The electrical cabinet as claimed in claim 1, **characterized in that** it comprises a functional ventilation unit (2b) fastened on the fastening means and comprising a ventilation system situated in the first subspace (E20).

3. The electrical cabinet as claimed in claim 1, **characterized in that** it comprises a functional ventilation unit (2b) fastened on the fastening means and comprising a ventilation system situated in the first space (E1).

4. The electrical cabinet as claimed in one of claims 1 to 3, **characterized in that** the cooling source comprises heat exchange fins (4) situated in the second subspace (E21).

5. The electrical cabinet as claimed in one of claims 1 to 4, **characterized in that** the partition (C) comprises heat exchange fins (4) situated in the second subspace (E21).

6. The electrical cabinet as claimed in one of claims 1 to 5, **characterized in that** it comprises at least two functional electrical units (2a) mounted along the separation plane (P) and **in that** it comprises an opening formed between the two functional electrical units (2a).

7. The electrical cabinet as claimed in one of claims 1 to 6, **characterized in that** a functional electrical unit (2a) comprises an electrical device (201) passing through the separation plane (P) so as to have a first part situated in the first space (E1) and a second part situated in the first subspace (E20.

8. The electrical cabinet as claimed in claim 7, **characterized in that** the second part of the electrical device (201) comprises a ventilation system.

9. The electrical cabinet as claimed in one of claims 1 to 8, **characterized in that** the second part of the electrical device (201) comprises a bearing surface positioned against the partition (C).

10. The electrical cabinet as claimed in one of claims 1 to 9, **characterized in that** it comprises a functional cooling unit (2c) fastened on the fastening means.

11. The electrical cabinet as claimed in claim 10, **characterized in that** the functional cooling unit (2c) comprises a heat exchange module passing through the separation plane (P) and the partition (C).

12. The electrical cabinet as claimed in one of claims 1 to 11, **characterized in that** the volume of the first space (E1) is greater than the volume of the second space (E2).
